# EUROPÄISCHE PATENTANMELDUNG

(11) **EP 2 221 966 A1**
(43) Veröffentlichungstag der Anmeldung: **25.08.2010**
(21) Anmeldenummer: 09015753.8
(22) Anmeldetag: 18.12.2009
(51) Int. Cl.: H03G 3/30, H01Q 23/00

(54) **Vorrichtung zur Bearbeitung von Telekommunikationssignalen für Antennen**

(30) Priorität: 19.12.2008 ES 200803663
(71) Anmelder: TELEVES, S.A., 15706 Santiago de Compostela (ES)
(72) Erfinder: Lopez Arca, Gumersindo, 15706 Santiago de Compostela (ES)
(74) Vertreter: Dosterschill, Peter

(57) **Zusammenfassung**

Die Erfindung betrifft eine Vorrichtung zur Bearbeitung von Telekommunikationssignalen für Antennen, insbesondere von Fernseh-, Rundfunk- oder Datensignalen, insbesondere in SMATV/MATV-Netzen, wobei die Vorrichtung in unmittelbarer Nähe einer Antenne angebracht ist, und wobei die Vorrichtung wenigstens ein Filter (2) und einen Verstärker (5) aufweist, wobei am Eingang der Vorrichtung ein Eingangssignalpegel anliegt und wobei am Ausgang der Vorrichtung ein Ausgangssignalpegel anliegt

Erfindungsgemäß ist vorgesehen, dass die Vorrichtung Mittel aufweist, die den Ausgangssignalpegel innerhalb vorbestimmter Grenzwerte unabhängig vom Eingangssignalpegel auf einen vorbestimmten Wert einstellen.

## Beschreibung

Die vorliegende Entdeckung betrifft eine Vorrichtung zur Bearbeitung von Telekommunikationssignalen für Antennen, insbesondere in SMATV/MATV-Netzen, nach dem Oberbegriff des Patentanspruchs 1.

SMATV/MATV-Netze bestehen im Wesentlichen aus einem Signalempfangssystem, aus einer Kopfeinheit und einem Verteilungsnetz.

Das Signalempfangssystem weist verschiedene Antennen auf, die Telekommunikationssignale empfangen, wobei diese Antennen im Allgemeinen im Freien, an Gebäuden, dort insbesondere an den höchst gelegenen Punkten, angeordnet und üblicherweise schwer zugänglich sind.

Die Antennen des Signalempfangssystems sind üblicherweise mit Vorrichtungen ausgestattet, die an die Antennenausgänge angeschlossen sind und die die empfangenen Signale verstärken. Damit wird die Qualität dieser Signale verbessert, so dass es möglich wird, die empfangenen Signale der oder den Kopfeinheiten in einer verbesserter Form zuzuführen.

Es sind bereits verschiedene Typen von Vorrichtungen bekannt, die in unmittelbarer Nähe der eigentlichen Antenne an diese angeschlossen sind und die dazu dienen, den Pegel der von der Antenne empfangenen Signale zu verstärken und gegebenenfalls Verluste zu kompensieren, die in einem nach geschaltetem Koaxialkabel auftreten.

Diese Vorrichtungen sind im Freien angeordnet und üblicherweise schwer zugänglich, so dass sich Arbeiten an den Vorrichtungen (Installation, Wartung, Reparatur, Austausch) schwer gestalten und risikobehaftet sind. Außerdem weisen diese Vorrichtungen einerseits fest vorgegebene Charakteristika (Gewinn, Bandbreite, Ausgangspegel, etc), die nicht verändert werden können. Andererseits variieren Charakteristika der zu empfangenen Signale, beispielsweise bei der Einführung neuer Dienste oder bei Änderungen von Signalparametern.

So können Antennen, die einen Verstärker in ihren Verbindungsgehäusen aufweisen, in Abhängigkeit des Signalpegels die Signale ausgangsseitig verzerren, wenn der Ausgangsspannungspegel seinen maximalen Pegelwert überschreitet, der eine Funktion des Eingangspegels (empfangen in der Antenne) und des sogenannten "Derating" oder Reduktion des Signalpegels in Abhängigkeit der Anzahl der zu verstärkenden Signale ist. Der verfügbare, störungs- beziehungsweise verzerrungsfreie Maximalpegel ist eine Funktion der Anzahl der Signale, deren Eingangspegel und deren Modulationsformats.
Die Anzahl der Signale ist im Allgemeinen vorab nicht bekannt. Außerdem kann das radioelektrische Spektrum zum Zeitpunkt der Installation der Antenne mit der Zeit variieren, zum Beispiel durch wetterbedingte Umstände, durch örtliche Änderungen von Antennenelementen oder auch durch das für die nächsten Jahre geplante Abschalten analoger (TV-) Systeme und das Aktivieren digitaler (TV-)Systeme.

Das spanische Patent ES 2183692B2 und das Europäische Patent EP 1199771, beide im Eigentum der Anmelderin, beziehen sich auf eine aktive Antenne, die mit einer Vorrichtung ausgestattet ist. Diese Vorrichtung ermöglicht die Verstärkung des Signals lediglich in den Fällen, in denen die Verstärkung benötigt wird. In den übrigen Fällen verhält sich diese Vorrichtung wie ein "herkömmliches" Anpassungselement mit minimalen Einfügeverlusten. Diese duale Ausgestaltung der Vorrichtung unterscheidet sie von anderen Vorrichtungen, die sich wie ein Verstärker im engeren Sinne verhalten, deren Ausgang nicht aktiviert ist, wenn keine Speisespannung zur Verfügung gestellt wird.

Demgegenüber wird bei der erfindungsgemäßen Vorrichtung die Möglichkeit bzw. die Nichtrealisierung der Verstärkung außerhalb der Antenne bzw. der Vorrichtung bewirkt, wobei sich die Verstärkungsvorrichtung in der typischen Signalverstärkungs-Kopfeinheit befindet.

Die Möglichkeit bzw. die Nichtrealisierung der Verstärkung in der Antenne kann dessen ungeachtet ungenügend sein, um Sättigungsprobleme zu vermeiden, wobei die bestehende Verbreitung von Verstärkungskopfvorrichtungen (unterschiedlicher Hersteller) zu berücksichtigen sind, wobei bei einer Vielzahl solcher Vorrichtungen eine Speisung ununterbrochen erfolgt.

Die erfindungsgemäße Vorrichtung wird zusätzlich in der Weise mit einem adaptiven System ausgestaltet, das eine Signalverzerrung vermeidet, einschließlich in den Fällen eines Signals erhöhter Spannung und unterbrochener Speisung.

Der Erfindung liegt die Aufgabe zugrunde, eine Vorrichtung der eingangs genannten Art zu schaffen, die Ausgangssignale einer besseren Qualität generiert.

Diese Aufgabe wird durch eine Vorrichtung gelöst, die in den Patentansprüchen definiert ist.

Mit der erfindungsgemäßen Vorrichtung wird eine Mehrzahl von Vorteilen erzielt.

Die erfindungsgemäße Vorrichtung zur Bearbeitung von Telekommunikationssignalen zeichnet sich zum einen durch den Vorteil aus, dass der dynamische Bereich vergrößert wird, und zum anderen durch den Vorteil, dass ein Betrieb mit vergleichsweise hohen Eingangspegeln ermöglicht wird. Sie passt sich selbsttätig an veränderte Signalcharakteristika an, in Abhängigkeit von Veränderungen der zu empfangenden Signale und/oder in Abhängigkeit von neuen Signalen, die empfangen werden sollen.

Außerdem ermöglicht die erfindungsgemäße Vorrichtung die Anpassung des Ausgangssignals unabhängig von dem Zeitpunkt der (Erst-)Installation (unabhängig von dem radioelektrischen Spektrum in diesem Zeitpunkt). Weiterhin ermöglicht die erfindungsgemäße Vorrichtung die Anpassung des Ausgangsegels an beliebige Arten von Verstärkungsvorrichtungen.

Die erfindungsgemäße - anpassungsfähige - Vorrichtung zur Bearbeitung von Telekommunikationssignalen stellt sich selbsttätig - ohne ein Mitwriken einer Bedienperson - auf den optimalen Empfangspegel ein. Wenn sich also aufgrund irgendwelcher Umstände die Empfangspegel verändern (Erhöhung der Leistung des Übertragers, Erhöhung oder Absenkung der Anzahl der Kanäle oder ihrer Beschaffenheit, z.B. analog bzw. digital) stellt sich die Vorrichtung auf den optimalen Pegel ein.

Die erfindungsgemäße Vorrichtung ist in dem eigentlichen Verbindungsgehäuse der Antenne untergebracht oder mit der Antenne mittels eines Koaxialkabels verbunden.

Ein Ausführungsbeispiel der erfindungsgemäßen Vorrichtung zur Bearbeitung von Telekommunikationssignalen für Antennen, insbesondere von Fernseh-, Rundfunk- oder Datensignalen, insbesondere in SMATV/MATV-Netzen, ist in unmittelbarer Nähe einer Antenne angebracht; wobei die Vorrichtung wenigstens ein Filter und einen Verstärker aufweist, und wobei am Eingang der Vorrichtung ein Eingangssignalpegel anliegt und wobei am Ausgang der Vorrichtung ein Ausgangssignalpegel anliegt Diese erfindungsgemäße Vorrichtung ist **dadurch gekennzeichnet, dass** sie Mittel aufweist, die den Ausgangssignalpegel innerhalb vorbestimmter Grenzwerte unabhängig vom Eingangssignalpegel auf einen vorbestimmten Wert einstellen.

Ein weiteres Ausführungsbeispiel der erfindungsgemäßen Vorrichtung ist **dadurch gekennzeichnet, dass** die Mittel, die den Ausgangssignalpegel innerhalb vorbestimmter Grenzwerte unabhängig vom Eingangssignalpegel auf einen vorbestimmten Wert einstellen, einen Detektor und ein variables Spannungseinstellungs- bzw. Dämpfungselement umfassen.

Ein weiteres Ausführungsbeispiel der erfindungsgemäßen Vorrichtung ist **dadurch gekennzeichnet, dass** die vorbestimmten Grenzwerte des Ausgangssignalpegels vor Installation der Vorrichtung programmiert sind.

Ein weiteres Ausführungsbeispiel der erfindungsgemäßen Vorrichtung ist **dadurch gekennzeichnet, dass** die Vorrichtung ein Durchlaßleitungselement aufweist, das einen Weg, der einen geringen elektrischen Widerstand aufweist, zwischen dem Eingang und dem Ausgang der Vorrichtung in den Fällen bereitstellt, in denen die Vorrichtung nicht gespeist wird und/oder der Verstärker außer Funktion ist.

Ein weiteres Ausführungsbeispiel der erfindungsgemäßen Vorrichtung ist **dadurch gekennzeichnet, dass** die Vorrichtung eine Kommunikationseinheit aufweist, die eine Kommunikation mit externen Programmiermitteln herstellt.

Ein weiteres Ausführungsbeispiel der erfindungsgemäßen Vorrichtung ist **dadurch gekennzeichnet, dass** die externen Programmiermittel mit der Vorrichtung mittels eines Kabels verbunden ist.

Ein weiteres Ausführungsbeispiel der erfindungsgemäßen Vorrichtung ist **dadurch gekennzeichnet, dass** die externen Programmiermittel drahtlos mit der Vorrichtung verbindbar sind.

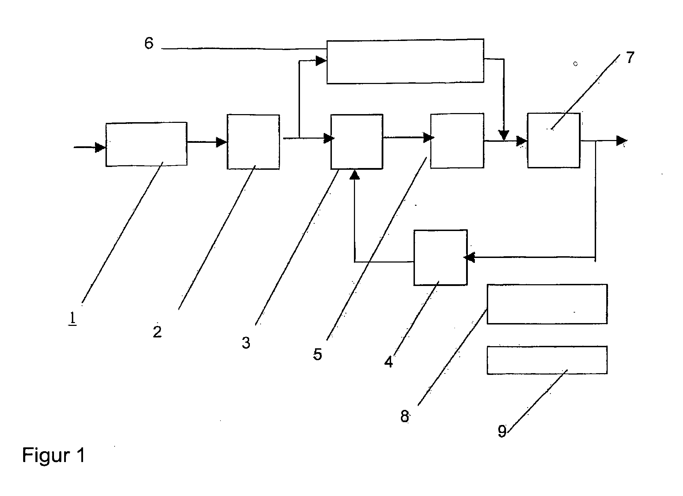

Zum besseren Verständnis der Erfindung wird die erfindungsgemäße Vorrichtung zur Bearbeitung von Telekommunikationssignalen für Antennen, insbesondere von Fernseh-, Rundfunk- oder Datensignalen, insbesondere in SMATV/MATV-Netzen, im Folgenden anhand der Figur beispielhaft beschrieben.

De Figur zeigt die Vorrichtung in Form eines Blockschaltbildes.

Die in der Figur dargestellte Vorrichtung, an deren Eingang ein Eingangssignalpegel anliegt und an deren Ausgang ein Ausgangssignalpegel anliegt, weist ein Impedanzanpassungselement 1 auf. Dieses besteht aus einer gedruckten Leitung.

Weiter weist die Vorrichtung ein Bandpaßfilter 2 auf, das das Signalempfangsband beispielsweise auf das Band von 420-870 MHz-begrenzt, wobei dieser Bandpaßfilter beispielsweise aus einem Tiefpaßfilter und aus einem Hochpaßfilter besteht.

Die Vorrichtung weist auch ein veränderliches Spannungseinstellelement bzw. insbesondere ein variables Dämpfungselement 3 auf, das in Abhängigkeit der Spannung, die ein Detektor 4 zuführt, den Signalpegel am Eingang eines Verstärkers 5 erhöht oder verringert.

Die Vorrichtung weist auch den vorgenannten Detektor 4 auf, der in Abhängigkeit vom Signalpegel am Ausgang der erfindungsgemäßen Vorrichtung eine vorbestimmte Spannung dem variablen Einstellelement 3 zuführt, weiterhin den vorgenannten Verstärker 5, der die Aufgabe hat, den Signalpegel am Eingang der Vorrichtung bis auf den optimalen Signalpegel am Ausgang der Vorrichtung zu verstärken.

Weiterhin weist die erfindungsgemäße Vorrichtung eine vorzugsweise gedruckte Durchlaßleitung 6 auf, die die Aufgabe hat, einen Weg, der einen geringen elektrischen Widerstand hat, zwischen ausgewählten Punkten der Schaltung in dem Fall bereitzustellen, in dem die Vorrichtung keine Speisung erhält und demzufolge der Verstärker 5 nicht in Funktion ist. Die Durchlaßleitung 6 überbrückt bei dem in der Figur dargestellten Verstärker 5 außer Betrieb ist, bildet er zusammen mit dem vorgeschalteten variablen Dämpfungselement 3 einen Widerstand, der größer ist als der Widerstand der Durchlaßleitung 6. Ist dagegen der Verstärker 5 in Betrieb, bildet er zusammen mit dem vorgeschalteten variablen Dämpfungselement 3 einen Widerstand, der kleiner ist als der Widerstand der Durchlaßleitung 6.

Weiterhin weist die Vorrichtung ein Hochpaßfilter 7 auf, das das Signal auf Frequenzen beispielsweise oberhalb von 470 MHz begrenzt. also Signale mit Frequenzen oberhalb dieses Wertes passieren lässt.

Die Vorrichtung weist Mittel auf, die den Ausgangssignalpegel innerhalb vorbestimmter Grenzwerte unabhängig vom Eingangssignalpegel auf einen vorbestimmten Wert einstellen. Dieser Wert ist vorzugsweise fest ist; er der vorbestimmte, insbesondere feste Wert liegt etwa im Bereich von etwa 75 bis 110 dbuv .

Wie in der Figur weiterhin schematisch dargestellt ist, weist die erfindungsgemäße Vorrichtung eine Kommunikationseinheit 8 auf sowie externe Programmiermittel 9, mit denen unterschiedliche Parameter der Vorrichtung. Z. B. Gewinn, Bandbreite, Ausgangspegel, Grenzwerte programmierbar sind.

Die Kommunikationseinheit 8 steht mit den variablen Schaltungskomponenten der Vorrichtung (z. B. 2, 3, 5) in Wirkverbindung und hat weiterhin die Aufgabe, die Kommunikation zwischen der Vorrichtung und den externen Programmiermitteln 9 herzustellen.. Diese externen Programmiermittel 9 umfassen Eingabemittel, zum Beispiel einen PDA, etc. und ermöglichen die Eingabe von Daten zur Programmierung der Vorrichtung. Die Kommunikation zwischen der Vorrichtung und den externen Programmiermittel erfolgt drahtlos oder alternativ über ein Kabel.

Die erfindungsgemäße Vorrichtung ist in unmittelbarer Nähe der Antenne bzw. an dieser selbst angeordnet, beispielsweise ist sie räumlich in die Antenne integriert.

Bezugszeichenliste:
- 1.: Impedanzanpassungselement
- 2.: Bandpaßflter
- 3.: Veränderliches Spannungseinstell- bzw. Dämpfungselement
- 4.: Detektor
- 5.: Verstärker
- 6.: Durchlaßleitungs-Element
- 7.: Hochpaßfilter
- 8.: Kommunikationseinheit
- 9.: Externe Programmierungsmittel

## Patentansprüche

1. Vorrichtung zur Bearbeitung von Telekommunikationssignalen für Antennen, insbesondere von Fernseh-, Rundfunk- oder Datensignalen, insbesondere in SMATV/MATV-Netzen, wobei die Vorrichtung in unmittelbarer Nähe einer Antenne angebracht ist, und wobei die Vorrichtung wenigstens ein Filter (2) und einen Verstärker (5) aufweist, wobei am Eingang der Vorrichtung ein Eingangssignalpegel anliegt und wobei am Ausgang der Vorrichtung ein Ausgangssignalpegel anliegt
**dadurch gekennzeichnet,**
**dass** die Vorrichtung Mittel aufweist, die den Ausgangssignalpegel innerhalb vorbestimmter Grenzwerte unabhängig vom Eingangssignalpegel auf einen vorbestimmten Wert einstellen.

2. Vorrichtung nach Anspruch 1, **dadurch gekennzeichnet, dass** der vorbestimmte Wert des Ausgangssignalpegels fest ist und/oder im Bereich von etwa 75 bis 110 dbuv liegt.

3. Vorrichtung nach einem der vorstehenden Ansprüche, **dadurch gekennzeichnet, dass** die Mittel, die den Ausgangssignalpegel innerhalb vorbestimmter Grenzwerte unabhängig vom Eingangssignalpegel auf den vorbestimmten Wert einstellen, einen Detektor (4) und ein variables Spannungseinstellelement (3) umfassen.

4. Vorrichtung nach einem der vorstehenden Ansprüche, **dadurch gekennzeichnet, dass** die vorbestimmten Grenzwerte vor Installation der Vorrichtung programmiert sind.

5. Vorrichtung nach einem der vorstehenden Ansprüche, **dadurch gekennzeichnet, dass** die Vorrichtung ein Durchlaßleitungselement (6) aufweist, das einen Weg, der einen geringen elektrischen Widerstand aufweist, zwischen dem Eingang und dem Ausgang der Vorrichtung in den Fällen bereitstellt, in denen die Vorrichtung nicht gespeist wird und/oder der Verstärker (5) außer Funktion ist.

6. Vorrichtung nach einem der vorstehenden Ansprüche, **dadurch gekennzeichnet, dass** die Vorrichtung eine Kommunikationseinheit (8) aufweist, die eine Kommunikation mit externen Programmiermitteln (9) herstellt.

7. Vorrichtung nach Anspruch 6, **dadurch gekennzeichnet, dass** die externen Programmiermittel (9) mit der Vorrichtung mittels eines Kabels verbunden ist.

8. Vorrichtung nach Anspruch 6, **dadurch gekennzeichnet, dass** die externen Programmiermittel (9) drahtlos mit der Vorrichtung verbindbar sind.
